(19) Europäisches Patentamt / European Patent Office / Office européen des brevets

(11) **EP 4 277 116 A1**

(12) **EUROPEAN PATENT APPLICATION**

(43) Date of publication:
**15.11.2023 Bulletin 2023/46**

(21) Application number: **22173330.6**

(22) Date of filing: **13.05.2022**

(51) International Patent Classification (IPC):
**H02P 23/14** $^{(2006.01)}$   **G05B 23/02** $^{(2006.01)}$
**H02K 11/20** $^{(2016.01)}$

(52) Cooperative Patent Classification (CPC):
**H02P 23/14; G06Q 10/06; G06Q 50/06;**
**H02K 11/20;** H02P 2207/01

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Aktiengesellschaft**
**80333 München (DE)**

(72) Inventors:
• **DEEG, Christian**
 **90518 Altdorf (DE)**
• **YAZGAN, Korhan**
 **34000 Istanbul (TR)**
• **KARAARSLAN, Burak**
 **34903 Istanbul (TR)**
• **ARDIC SERPEN, Burcu**
 **34752 Istanbul (TR)**

(74) Representative: **Siemens Patent Attorneys**
**Postfach 22 16 34**
**80506 München (DE)**

(54) **METHODS AND SYSTEMS FOR MONITORING OF AN ELECTRICAL MACHINE**

(57) A method for monitoring of an electrical machine (1) during its operation, the method comprising:
- detecting in a detector (3) a stray magnetic field of the electrical machine (1),
- based on the detected stray magnetic field and on an electrical model (8) of the electrical machine (1), (S110) determining operating point data of the electrical machine (1),
- using the electrical model (8) and the operating point data to determine a mechanical output power and power losses of the electrical machine (1),
- (S120) determining an efficiency of the electrical machine (1) from the mechanical output power and from the power losses.

FIG 3

## Description

The subject matter disclosed herein relates to methods and systems for monitoring of an electrical machine.

Furthermore, the subject matter disclosed herein relates to a computer program comprising instructions to cause the above-mentioned system to execute the above-mentioned method and to a computer-readable medium having stored thereon such computer program.

To evaluate the carbon footprint of an electrical machine or to yield information about its operating costs, it is inevitable to obtain information about the according electrical energy consumption by capturing the electrical input power during operation, i.e., taking into account the actual/individual load situation of the electrical machine. IIoT devices, e.g., soft sensors, used for condition monitoring can usually provide only motor torque and motor speed, which are not sufficient to determine motor efficiency and hence motor energy consumption.

One possible solution to the above problem of taking the real load situation into account is to use a power meter (a very costly device) connected to the motor terminals and a torque/speed sensing device connected to the shaft during the full monitoring period which inhibits monitoring, when a plurality of motors is to be monitored, due to effort and cost. An energy consumption calculation in retrospect (based on easy-to-obtain quantities like recorded torque and speed values only) would not be possible.

In offline scenarios, where a certain load profile and certain machine properties must be assumed, with the latter usually only being available in fixed/discrete steps (e.g., full load efficiency, half load efficiency etc.) the result is a single valued kWh quantity for a predefined period of time and under comparatively rough assumptions. This cannot reflect real conditions under which the machines are in operation.

Subject matter disclosed herein provides a solution to the above-stated problems in form of a method for monitoring of an electrical, e.g., electrical rotary machine, in particular of a plurality (two, three, ten, hundred or even more) of electrical machines, during its (their) operation, in particular in its continuous operation. The method comprises steps of detecting, in a detector, a stray magnetic field of the electrical machine (of each electrical machine); based on the detected stray magnetic field and on an electrical model of the electrical machine, determining operating point data of the electrical machine; using the electrical model and the operating point data to determine a mechanical output power $p_{mech}(t)$ and power losses $p_{losses}(t)$ of the electrical machine; and determining (by continuous, in particular uninterrupted calculation during machine's operation) an efficiency $\eta(t)$ of the electrical machine from the mechanical output power and from the power losses. E.g., a formula can be used:

$$\eta(t) = \frac{p_{mech}(t)}{p_{mech}(t) + p_{losses}(t)}.$$

It will be appreciated that the terms "continuous, uninterrupted" refer to scenarios, where an interruption or discontinuity may happen unwillingly, due some unexpected events, like fire, power outage, natural disaster and alike.

The method allows a load-dependent calculation of the efficiency of the electrical machine during its operation.

The term operation here means that the electrical machine is in use as a field device in a factory, automation facility or plant, i.e., a place, where the load of the electrical machine varies. This implies that no additional equipment can be used to monitor each and every electrical machine. This would introduce additional costs, but, most importantly, is very time consuming. A change of a load of an electrical machine is multidimensional problem and a variety of quantities can influence losses of the machine, e.g., torque, rotational speed, thermal conditions, and a few more. This implies that the electrical machine usually operates in a dynamical environment and its real efficiency deviates from the efficiency that was measured in a standardized procedure under standardized conditions during a machine's type test, away from the individual operation under real world conditions.

In an embodiment, the power losses $p_{losses}(t)$ comprise but are not limited to ohmic losses of stator and rotor, core losses, windage and friction losses, load dependent additional losses.

In an embodiment, the detector comprises a magnetic field detector for receiving the stray magnetic field. The stray magnetic field encompasses characteristic frequencies. By performing frequency analysis, a stator frequency, i.e., a frequency of the currents in the stator winding, and a frequency of the currents in rotor winding can be determined from the stray magnetic field. These two frequencies can be used to determine rotational speed, slip and further quantities relevant for determining the operating point of the electrical machine.

In an embodiment, the method further comprises calculating energy consumption of the electrical machine based on the mechanical output power and the energy efficiency of the electrical machine for a determined time interval. This can be performed by calculation of the electrical input power $p_{el}(t)$ and integrating it for the determined time interval

$$W_{el} = \int_{t1}^{t2} p_{el}(t)dt.$$

In an embodiment, the method further comprises visualizing the energy efficiency of the electrical machine as a function of time.

In an embodiment, the method further comprises, if the energy efficiency is lower than some predetermined threshold value, notifying the undercutting of the threshold value.

In an embodiment, the method further comprises:

- using a reference electrical model of a reference electrical machine and the operating point data of the (original) electrical machine to determine a mechanical output power and power losses of the reference electrical machine,
- determining a reference efficiency of the reference electrical machine from the mechanical output power and from the power losses,
- comparing the reference efficiency with the efficiency of the (original) electrical machine.

In an embodiment, the method further comprises, if the reference electrical machine is more efficient than the electrical machine, recommending, e.g., regularly recommending the use of the more efficient further electrical machine.

In an embodiment, the method comprises recommending, e.g., recommending regularly to optimize the efficiency of the electrical machine.

In an embodiment, the recommendation comprises visualization of a carbon footprint of the electrical machine, wherein the carbon footprint is calculated based on the machine's efficiency.

In an embodiment, the recommendation can comprise a recommendation of a change in the operating conditions of the machine, e.g., it can be recommended to changes the voltage/flux (of the inverter of the electrical machine), the load (e.g., to reduce it, if the machine works in overload, or to increase it, if the machine works in underload), etc.

In an embodiment, the method further comprises calculating a reference energy consumption of the reference electrical machine and an energy consumption of the (original) electrical machine for a predetermined time interval and comparing the reference energy consumption of the reference electrical machine with the energy consumption of the (original) electrical machine.

In an embodiment, the method further comprises receiving, e.g., in an acceleration detector, mechanical vibrations of the electrical machine and using detected mechanical vibrations to determine the operating point data. From mechanical vibrations, by performing a spectral analysis, the rotational speed of the rotor can be determined directly. In this case the method is faster.

In an embodiment, the detector comprises an acceleration detector.

In an embodiment, the determining the operating point data of the electrical machine comprises determining rotational speed and torque of the electrical machine.

In an embodiment, the electrical model is designed as an extended equivalent circuit. The extended equivalent circuit comprises, among other machine-specific parameters (main inductance $X_h$ (main flux), stator leakage inductance $X_1$ and rotor leakage inductance $X'_2$ (leakage flux), rotor resistance $R'_2$ (for rotor winding losses), stator resistance $R_1$ (for stator winding losses), $R_{fe}$ (for core losses)), an additional resistance $R_{add}$ that is responsible for additional losses.

The losses can be determined by solving the extended equivalent circuit and calculating the power on corresponding resistances.

In an embodiment, the method further comprises determining parameters of the extended equivalent circuit from/by using nameplate data.

The problem is also solved by providing a system having a detector for detecting a stray magnetic field of an electrical machine and a computing device adapted to perform the above-described method.

In an embodiment, the system is designed as an IIoT-enabled device (IIoT:=industrial internet of things).

The above and other objects and advantages of the invention will be apparent upon consideration of the following detailed description of certain aspects indicating only a few possible ways which can be practiced. The description is taken in conjunction with the accompanying drawings, in which like reference characters refer to like parts throughout, and in which:

FIG 1    shows monitoring of an electrical rotary machine in operation,

FIG 2    an extended electrical circuit of an electrical machine,

FIG 3    a flow chart of a method for monitoring energy consumption of a machine in operation.

The reference signs used in the figures and in the claims are used for demonstrative purposes and shall not be considered as a limitation of corresponding claim features.

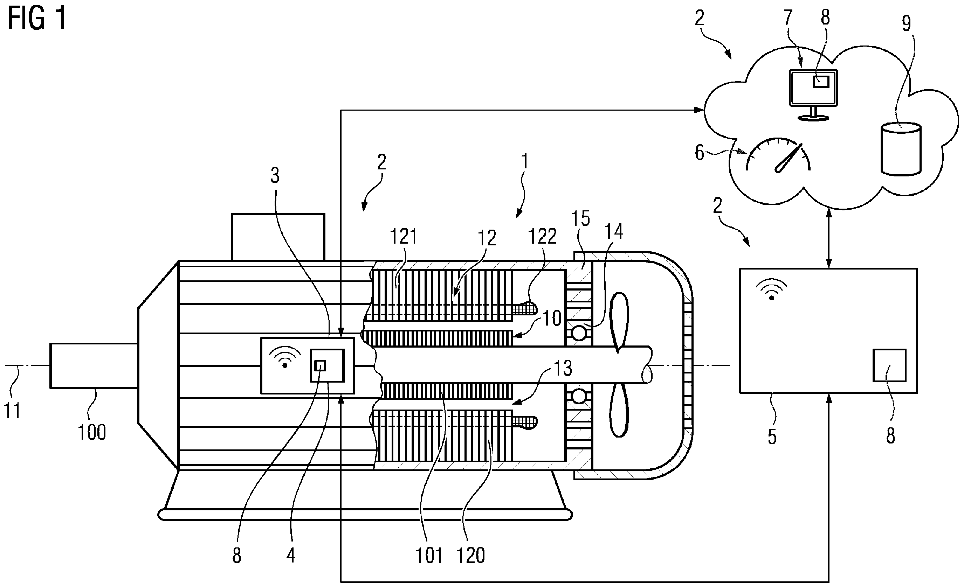

FIG 1 shows an electric rotary machine 1. The machine 1 is connected to an operating voltage and is in operation. The machine 1 is designed as an asynchronous machine, for example as an asynchronous motor, and has a rotor 10 rotatable about a rotation axis 11 and a stator 12 surrounding the rotor 10, wherein a gap 13, which is designed in particular as an air gap, is located between the rotor 10 and the stator 12. The axis of rotation 11 defines an axial direction and a radial direction. The rotor 10 comprises a shaft 100 and a rotor laminate package 101. The stator 12 comprises a stator laminate package 120 with stator windings 121, wherein the stator laminate stack 120 is constructed from a plurality of laminated electrical sheets. The stator windings 121 extend axially through the stator laminate stack 120 and form winding heads 122 at the axial ends of the stator laminate package 120. The shaft 100 of the rotor 10 is supported by bearings 14. The rotor 10 and the stator 12 are housed in a closed machine housing 15.

FIG 1 further illustrates a system 2 for monitoring of the electrical rotary machine 1 during its operation.

The system 2 comprises a sensor device 3 - a detector - and a computing system 4, 5, 6, 7. The computing device 4, 5, 6, 7 may generally comprise hardware and/or software components. For example, it may comprise a first 4 and a second hardware component 5, a displaying device 6 and a cloud computing unit 7.

The hardware components (computing units) 4, 5, the displaying device 6, and the cloud computing unit 7 may all be structurally separated from each other. The sensor device 3, the first hardware component 4 and second hardware component 5 may have a (e.g., two-way, preferably wireless) data connection to a cloud, e.g., to the cloud computing unit 7. The second hardware component 5 may, for example, take the form of a mobile device, e.g., a handheld device such as a smartphone or a tablet. The displaying device 6 can comprise, for example, as a dashboard. The first computation unit 4 may be arranged in the sensor device 3. The sensor device 3 and/or the first hardware component 4 can be connectable to the second hardware component 5 via a (e.g., bilateral) wireless connection for the purpose of two-way data transmission.

In an embodiment, the system 2 may is an Industrial Internet of Things (IIoT) enabled system.

The detector 3 is attached to the machine housing 15 and has usually small dimensions compared to the machine 1 (see FIG 1). The machine 1 may be designed as a fin-cooled asynchronous machine, and the detector 3 may be attached to the cooling fins of the asynchronous machine.

The detector 3 is designed to detect a stray magnetic field outside the machine 1. For that the detector may comprise a magnetic field detector.

In an embodiment, the detector 3 can be designed to detect mechanical vibrations of the electrical machine 1. For that the detector may encompass an acceleration detector (not shown).

The computing system 4, 5, 6, 7 determines operating point data of the electrical machine 1 during its operation. The calculation is based on the detected stray magnetic field and on an electrical model 8 of the electrical machine 1. The electrical model 8 can be stored on at least one of the computing units 4, 5, 7 of the computing system.

The operating point data can comprise but not limited to rotational speed, torque (load), currents, losses, etc.

In an embodiment, at least one of the computing units 4, 5, 7 of the computing system calculates from the detected stray magnetic field (that encompasses a plurality of frequencies) a stator frequency, i.e., a frequency of the currents in the stator windings 121 and a frequency of the currents in the rotor windings 101. These two frequencies are used to calculate rotational speed, slip s etc. of the machine 1.

In an embodiment, at least one of the computing units 4, 5, 7 of the computing system calculates the rotational speed from the detected mechanical vibrations of the electrical machine. Here also a frequency analysis is performed to "extract" the needed frequency from the spectrum of the mechanical vibrations.

In an embodiment, at least one of the computing units 4, 5, 7 of the computing system calculates a mechanical output power and power losses of the electrical machine 1 using the electrical model 8 and the operating point data and determines an efficiency $(\eta(t) = \frac{p_{mech}(t)}{p_{mech}(t) + p_{losses}(t)})$ of the electrical machine 1 from the mechanical output power and from the power losses.

The power losses can be at least one of, but not limited to rotor winding losses, stator winding losses, core losses, additional losses.

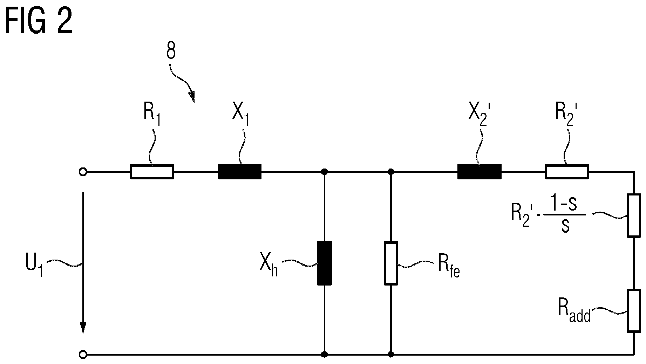

To calculate the mechanical output power and the power losses at least one of the computing units 4, 5, 7 solves the electrical model 8 based on the operating point data (voltage, speed, etc.). The electrical model 8 can comprise or can be designed as extended equivalent circuit that comprises a parameter $R_{add}$ to account for additional losses (see FIG 2). The additional losses can be accounted for, as shown in FIG 2, by including a resistance $R_{add}$ into the circuit 8.

The extended equivalent circuit 8 is, therefore, determined by following machine-specific parameters - main inductance $X_h$ (main flux), stator leakage inductance $X_1$ and rotor leakage inductance $X'_2$ (leakage flux), rotor resistance $R'_2$ (for rotor winding losses), stator resistance $R_1$ (for stator winding losses), $R_{fe}$ (for core losses) and $R_{add}$ (for additional losses) (see FIG 2). The additional resistance $R_{add}$ is located in the rotor branch of the extended equivalent circuit (between $R_{fe}$ and $R'_2$).

In an embodiment, the parameters of the extended equivalent circuit 8 are determined by using information of the nameplate of the electrical machine 1, e.g., number of pole pairs and/or size of the electrical machine 1 (e.g., its shaft 100 height).

At this point it should be emphasized that the detector 3 need not be directly connected, e.g., by a wire, to any machine sensors inside of (or even outside) the machine 1.

The electrical model 8 can, for example, be downloaded from the cloud, e.g., from the cloud computing unit 7 or from a cloud database 9, by means of the second computing unit 5 and transmitted to the first computing unit 4.

In an embodiment, the electrical model 8 can be used for calculation at the cloud, i.e., by the cloud computing unit 7.

In an embodiment, at least one of the computing units 4, 5, 7 of the computing system calculates an energy consumption ($W_{el}$) of the electrical machine 1 based on the mechanical output power and the energy efficiency of the electrical machine 1 for a determined time interval. This can be performed by calculating an electrical input power $(p_{el}(t) = \frac{p_{mech}(t)}{\eta(t)})$ and then by integrating the electrical input power over the predetermined time interval

$$W_{el} = \int_{t1}^{t2} p_{el}(t)dt.$$

In an embodiment, the displaying device 6 visualizes the energy efficiency of the electrical machine 1 as a function of time. The displaying device 6 can comprise a web service for displaying the energy efficiency remotely. FIG 1 shows the displaying device 6 located in a cloud. It will be, however, appreciated by the skilled person that the displaying device 6 can be a part of a computer unit, e.g., of the second computer unit 5, of the cloud computer unit 7 or of the first computer unit 4. Such visualization of the energy efficiency of the electrical machine 1 during its operation provides permanent guidance for the machine's operator, such that s/he can immediately during machine's operation (which is sometimes months or even years) perform changes in the operating conditions of the machine to increase the efficiency of the machine's operation, e.g., changes voltage/flux (of the inverter), load (e.g. reduces it, if the machine works in overload, or increases it, if the machine works in underload), etc., or to replace the machine by a more efficient one.

To facilitate the guidance, in an embodiment, at least one of the computing units 4, 5, 7 of the computing system or the displaying device 6 notifies an undercutting of a predetermined threshold value of the energy efficiency. The notification can be in form of a message, e.g., of an e-mail, or acoustic or visual signal. It will be appreciated by the skilled person that the form of the notification can be adapted to machine's operator needs and/or preferences. E.g., at least one of the computing units 4, 5, 7 can notify by using the displaying device 6 for the notification.

In an embodiment, at least one of the computing units 4, 5, 7 of the computing system uses a reference electrical model of some specified reference electrical machine and the operating point data of the (original) electrical machine 1 to determine a mechanical output power and power losses of the specified reference electrical machine, determines a reference efficiency of the reference electrical machine from its mechanical output power and its power losses, and compares the reference efficiency with the efficiency of the (original) electrical machine 1.

In this way it is possible to analyze the efficiency of the electrical machine 1, which is currently in operation with some other reference electrical machine, which is preferably available on the market.

To improve the efficiency of the system, in which the electrical machine 1 is operating, in an embodiment, at least one of the computing units 4, 5, 7 of the computing system or the displaying device 6 recommends, e.g., regularly how to optimize energy consumption, e.g., by adjusting the operating parameters of the machine 1 or by using the reference electrical machine, if the above comparison shows that the reference electrical machine is more efficient than the original electrical machine 1.

To further improve the guidance, in an embodiment, at least one of the computing units 4, 5, 7 of the computing system calculates a reference energy consumption of the reference electrical machine and the energy consumption of the (original) electrical machine 1 for a predetermined time interval and compares the reference energy consumption of the reference electrical machine with the energy consumption of the (original) electrical machine 1. In this way, the operator can be notified by only two numbers. If the reference electrical machine is more energy efficient than the original machine 1 a specified notification can be issued, which, e.g., suggests that the operating conditions of the original machine 1 should be optimized or the original machine should be replaced by a more efficient one.

It will be appreciated by the skilled person that the above-described comparison of the original electrical machine 1 with a specified reference electrical machine is also valid in the context of prediction of a future energy consumption.

Indeed, the determined/collected operating point data of the (original) electrical machine 1 usually contains information about load (torque) under which the machine 1 has been operating. If the load is not determined, it must be possible to determine the load based on other physical quantities contained in the operating point data of the (original) electrical machine 1. Otherwise, the operating point is not determined. Assuming that the future load of the original electrical machine 1 stays essentially the same (i.e., exhibiting a comparable load profile) e.g., a prediction for the energy consumption of the original machine 1 can be made. But also a prediction of the energy consumption of the reference electrical machine can be calculated, since its reference electrical model is available. By visualizing this comparison and notifying (constantly) the operator of predicted energy consumption savings, not only the guidance can be improved, but also the energy efficiency of the system, in which the machines are operating.

In other words, by using the torque/speed data of a monitored machine 1 it is not only possible to derive the energy efficiency displaying for that specific machine but also for a possible replacement (reference) machine (e.g., IE4 motor instead of IE2 motor), by using the electrical model of that replacement machine and pretending to operate it under the exact same conditions (voltage, frequency, torque) that apply to the original machine 1. This enables reliable ROI statements, supporting retrofit business, as well as the decarbonization targets of the European Commission.

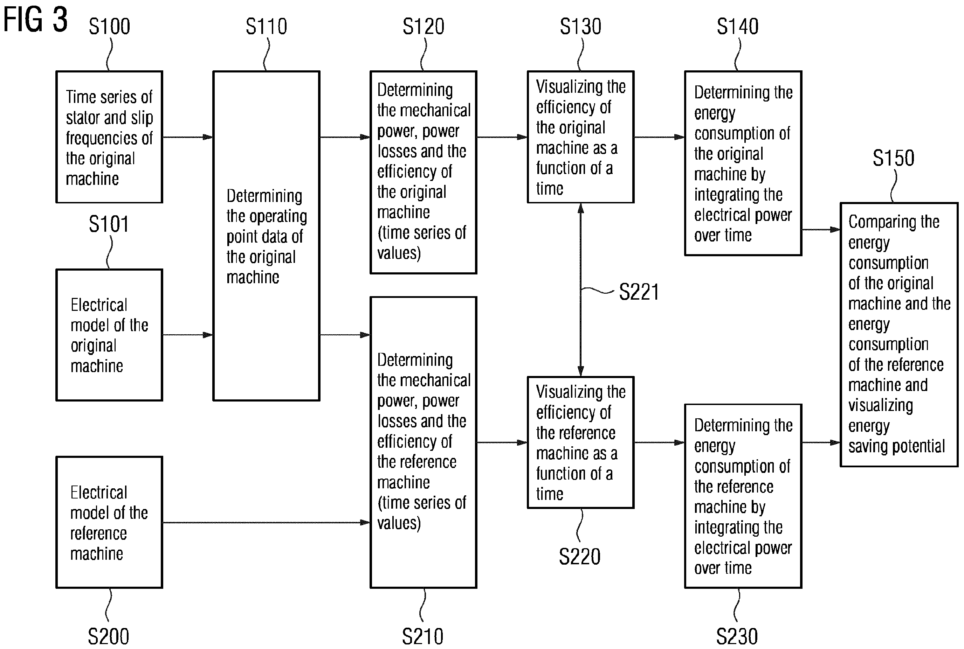

FIG 3 illustrates an embodiment of a method that was discussed above. Steps S100 to S140 regard the operating (original) machine 1 only.

In an embodiment, in S100 time series of stator, i.e., the frequency of the currents in the stator windings 121, and slip frequencies of the original, operating machine 1 are determined based on the detected stray magnetic field.

In an embodiment, in S101 an electrical model 8 of the operating machine 1 is provided, e.g., downloaded from a cloud, or uploaded into a cloud, or determined based on nameplate parameters.

In an embodiment, in S110 operating point data of the operating machine 1 is determined based on time series of stator and slip frequencies and on the electrical model 8.

In an embodiment, in S120 the mechanical power $p_{mech}$, power losses and the efficiency of the original, operating machine is determined (as time series of values).

In an embodiment, in S130 the efficiency of the original machine as a function of a time is visualized.

In an embodiment, in S140 the energy consumption of the operating machine 1 is determined by integrating the electrical input power $p_{el}$ (calculated from the mechanical power and the efficiency

$$p_{el}(t) = \frac{p_{mech}(t)}{\eta(t)})$$ over time.

In an embodiment, in S200 a reference electrical model of a reference machine is provided.

In an embodiment, in S210 mechanical power, power losses and a reference efficiency of the reference machine is determined (as time series of values) based on the reference electrical model and the operating data of the original machine 1.

In an embodiment, in S220 the efficiency of the reference machine is visualized as a function of a time.

In an embodiment, in S221 the efficiencies of the operating machine 1 and of the reference machine are compared and, e.g., visualized at the same time on the same graph.

In an embodiment, in S230 the energy consumption of the reference machine is determined by integrating the electrical input power $p_{el}$ over time.

In an embodiment, in S150 the energy consumption of the original machine and the energy consumption of the reference machine are compared and an energy saving potential is visualized.

It will be appreciated by the skilled person that the above-described can be applied to a generator mode of the electrical machine.

The above-described embodiments of the present disclosure are presented for purposes of illustration and not of limitation. In particular, the embodiments described with regard to figures are only few examples of the embodiments described in the introductory part. Technical features that are described with regard to systems can be applied to augment methods disclosed herein and *vice versa.*

**Claims**

1. A method for monitoring of an electrical machine (1) during its operation, the method comprising:

   - detecting in a detector (3) a stray magnetic field of the electrical machine (1),
   - based on the detected stray magnetic field and on an electrical model (8) of the electrical machine (1), (S110) determining operating point data of the electrical machine (1),
   - using the electrical model (8) and the operating point data to determine a mechanical output power and power losses of the electrical machine (1),
   - (S120) determining an efficiency of the electrical machine (1) from the mechanical output power and from the power losses.

2. Method of Claim 1, further comprising:

   - (S140) calculating energy consumption of the electrical machine (1) based on the mechanical output power and the energy efficiency of the electrical machine (1) for a determined time interval.

3. Method of Claim 1 or 2, further comprising:

   - (S130) visualizing the energy efficiency of the electrical machine (1) as a function of time.

4. Method of any one of Claims 1 to 3, further comprising: if the energy efficiency is lower than some predetermined threshold value, notifying the undercutting of the threshold value.

5. Method of any one of Claims 1 to 4, further comprising:

   - (S200) using a reference electrical model (8) of a reference electrical machine and the operating point data of the electrical machine (1) to determine a mechanical output power and power losses of the reference electrical machine,
   - (S210) determining a reference efficiency of the reference electrical machine from the mechanical output power and from the power losses,
   - (S221) comparing the reference efficiency with the efficiency of the electrical machine (1).

**6.** Method of Claim 5, further comprising:

> - if the reference electrical machine (1) is more efficient than the electrical machine (1), recommending the use of the more efficient further electrical machine (1).

**7.** Method of Claim 5 or 6, further comprising:

> - (S230) calculating a reference energy consumption of the reference electrical machine and (S140) an energy consumption of the electrical machine (1) for a predetermined time interval and (S150) comparing the reference energy consumption of the reference electrical machine with the energy consumption of the electrical machine (1).

**8.** Method of any one of Claims 1 to 7, further comprising:

> - receiving mechanical vibrations of the electrical machine (1) and using detected mechanical vibrations to determine the operating point data.

**9.** Method of any one of Claims 1 to 8, wherein the electrical model is designed as an extended equivalent circuit (8).

**10.** Method of Claim 9, further comprising:

> - determining parameters of the extended equivalent circuit (8) from/by using nameplate data.

**11.** A system having a detector (3) for detecting a stray magnetic field of an electrical machine (1) and a computing device (4,5,6,7) adapted to perform a Method of any one of Claims 1 to 10.

**12.** System of Claim 11, wherein the system is designed as an IIoT-enabled device.

**13.** System of Claim 11 or 12, wherein the detector (3) comprises a magnetic field detector configured to receive a stray magnetic field of the electrical machine and an acceleration detector configured to receive mechanical vibrations of the electrical machine.

**14.** A computer program comprising instructions to cause a System of any one of Claims 11 to 13 to execute a Method of any one of Claims 1 to 10.

**15.** A computer-readable medium having stored thereon the computer program of Claim 14.

FIG 1

EP 4 277 116 A1

FIG 2

FIG 3

S100 — Time series of stator and slip frequencies of the original machine

S101 — Electrical model of the original machine

S200 — Electrical model of the reference machine

S110 — Determining the operating point data of the original machine

S120 — Determining the mechanical power, power losses and the efficiency of the original machine (time series of values)

S210 — Determining the mechanical power, power losses and the efficiency of the reference machine (time series of values)

S130 — Visualizing the efficiency of the original machine as a function of a time

S220 — Visualizing the efficiency of the reference machine as a function of a time

S221

S140 — Determining the energy consumption of the original machine by integrating the electrical power over time

S230 — Determining the energy consumption of the reference machine by integrating the electrical power over time

S150 — Comparing the energy consumption of the original machine and the energy consumption of the reference machine and visualizing energy saving potential

EP 4 277 116 A1

# EP 4 277 116 A1

**EUROPEAN SEARCH REPORT**

Application Number

EP 22 17 3330

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 907 878 A1 (SIEMENS AG [DE]) 10 November 2021 (2021-11-10) | 1,3,9, 11,12, 14,15 | INV. H02P23/14 G05B23/02 H02K11/20 |
| Y | * paragraph [0034]; claims 1,7; figures 1-3 * | 2,4-8, 10,13 | |
| A | Beitz: "Dubbel – Taschenbuch für den Maschinenbau, 20. Auflage" In: "Dubbel – Taschenbuch für den Maschinenbau", 1 January 2001 (2001-01-01), Springer, Berlin [u.a.] 027081, XP055281024, ISBN: 978-3-540-67777-2 pages V23-V25, * paragraph [3.2.3]; figure 12 * | 1,11,14, 15 | |
| Y | EP 3 322 088 A1 (SIEMENS AG [DE]) 16 May 2018 (2018-05-16) * paragraph [0028] – paragraph [0029]; claims 9-11; figures 1-2 * | 2,8,13 | |
| Y | DE 10 2012 103245 A1 (LENZE AUTOMATION GMBH [DE]) 17 October 2013 (2013-10-17) * paragraph [0041] – paragraph [0045]; figure 1 * | 10 | TECHNICAL FIELDS SEARCHED (IPC) H02P G05B H02K |
| Y | US 2022/011763 A1 (NEGRI ORI [IL] ET AL) 13 January 2022 (2022-01-13) * paragraph [0110] – paragraph [0155]; figures 7, 13 * | 4-7 | |

The present search report has been drawn up for all claims

| Place of search | Date of completion of the search | Examiner |
|---|---|---|
| Munich | 18 October 2022 | Landi, Matteo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.............................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 17 3330

This annex lists the patent family members relating to the patent documents cited in the above-mentioned European search report.
The members are as contained in the European Patent Office EDP file on
The European Patent Office is in no way liable for these particulars which are merely given for the purpose of information.

18-10-2022

| Patent document cited in search report | | Publication date | Patent family member(s) | | Publication date |
|---|---|---|---|---|---|
| EP 3907878 | A1 | 10-11-2021 | EP | 3907878 A1 | 10-11-2021 |
| | | | WO | 2021224024 A1 | 11-11-2021 |
| EP 3322088 | A1 | 16-05-2018 | CN | 110063023 A | 26-07-2019 |
| | | | EP | 3322088 A1 | 16-05-2018 |
| | | | EP | 3513493 A1 | 24-07-2019 |
| | | | US | 2019267923 A1 | 29-08-2019 |
| | | | WO | 2018086830 A1 | 17-05-2018 |
| DE 102012103245 | A1 | 17-10-2013 | NONE | | |
| US 2022011763 | A1 | 13-01-2022 | AU | 2019375200 A1 | 17-06-2021 |
| | | | CN | 113287072 A | 20-08-2021 |
| | | | EP | 3877819 A1 | 15-09-2021 |
| | | | JP | 2022507110 A | 18-01-2022 |
| | | | KR | 20210091737 A | 22-07-2021 |
| | | | US | 2022011763 A1 | 13-01-2022 |
| | | | WO | 2020095303 A1 | 14-05-2020 |

EPO FORM P0459

For more details about this annex : see Official Journal of the European Patent Office, No. 12/82